# EUROPEAN PATENT APPLICATION

(11) **EP 1 881 748 A2**
(43) Date of publication of application: **23.01.2008**
(21) Application number: 07011367.5
(22) Date of filing: 11.06.2007
(51) Int. Cl.: H05K 1/03

(54) **Multi-layer laminate substrates useful in electronic type appliactions**

(30) Priority: 22.06.2006 US 472713
(71) Applicant: E.I. du Pont de Nemours and Company, Wilmington, DE 19898 (US)
(72) Inventor: Kanakarajan, Kuppusamy, Dublin Ohio 43017 (US); Karasawa, Hiroyuki, Yokohama-shi Kanagawa-ken 231-0842 (JP)
(74) Representative: Towler, Philip Dean

(57) **Abstract**

A laminate for electronic-type applications having a conductive layer and a dielectric multilayer. The dielectric multilayer comprises at least three layers: i. an adhesive layer; ii. a low coefficient of thermal expansion layer; and iii. a curl balancing layer. Optionally, the laminate can also comprise a second conductive layer bonded to the curl balancing layer.

## Description

### BACKGROUND OF THE INVENTION

### Field of the Invention

The present invention relates generally to multilayer laminates, useful as base substrates for mounting electronic circuits, circuit devices and/or the like. More specifically, the present invention is directed to curl resistant, delamination resistant multilayer composites, comprising two or more polyimide layers and one or more metal layers.

### Description of the Related Art

US 2003/0038379 to Kawasaki et al., is directed to laminate films for mounting electronic devices, where a conductive layer and an insulating layer are bonded by thermo-compression bonding. Polyimides tend to have high coefficients of thermal expansion ("CTEs"), and as a result, laminates of polyimide and metal can be prone to unwanted curling. While a lower CTE polyimide might diminish unwanted curl, lower CTE polyimides tend to have lower bond strengths to metal. A need therefore exists for polyimide/metal laminates that have a diminished tendency to curl, while also having advantageous resistance to unwanted delamination.

### SUMMARY OF THE INVENTION

The present invention is directed to a multilayer laminate comprising at least one conductive layer, and a dielectric multilayer. The dielectric multilayer comprises: i. an adhesive layer adjacent to the conductive layer, ii. a low coefficient of thermal expansion layer adjacent to the adhesive layer, and iii. a curl balancing layer adjacent to the low coefficient of thermal expansion layer.
Optionally, the curl balancing layer is used as a second 'adhesive layer' to aid in bonding the dielectric multilayer to a second conductive layer (e.g. a second metal foil) or other substrate or material.

The multilayer laminates of the present invention can be made by thermal compression bonding step followed by heat-sealing bonding step to obtain bond values between 1.0 and 25 N/cm, greatly increasing processing speed and lowering cycle times.

### DESCRIPTION OF THE PREFERRED EMBODIMENTS

In one embodiment, a multilayer laminate is constructed, comprising at least one conductive layer and a dielectric multilayer, where the dielectric multilayer comprises: i. an adhesive layer adjacent to the conductive layer, ii. a low coefficient of thermal expansion layer adjacent to the adhesive layer, and iii. a curl balancing layer adjacent to the low coefficient of thermal expansion layer. In such embodiments, the conductive layer and dielectric multilayer can be bonded together by a thermo-compression bonding step. The bonding step generally requires at least two compression nip rollers. The compression nip roller pressing the conductive layer (e.g. the metal foil) is generally set at a temperature higher than the glass transition temperature of the adhesive layer. However, the compression nip roller pressing the dielectric layer is generally set at a temperature that is lower than the glass transition temperature of the adhesive layer. By adjusting temperatures of both compression nip rollers in this way, unwanted blocking (i.e. sticking to the roller) of the thermally compressed dielectric-metal laminate can generally be prevented when the laminate is wound into a roll, or roll form.

In such embodiments, the thermally compressed dielectric-metal laminate can generally be wound into rolls without blocking or sticking (to itself), particularly with the use of an interleaf. These rolls can then be placed into a high-energy convective oven (or alternatively, a radiant energy oven) to then bond (or "heat seal") the conductive layer to the adhesive layer via a heat-sealing step. By heat sealing the dielectric-metal laminate in this fashion, i.e. as a wound-up roll, processing cycle times can be reduced and higher bond values can be obtained.

In another embodiment, the thermally compressed laminate can be subsequently heated at higher temperature, using an in-line, continuous feed radiant heat oven or convective heat oven (or a combination of radiant heat and convective heat) to provide a useful seal between the conductive layer and dielectric multilayer.

In one embodiment, a dielectric-metal laminate is used to support (and electrically interconnect) electronic components or devices. In such applications, a conductive layer is bonded to a multilayer dielectric, and thereafter, metal is selectively subtracted away, such as by conventional lithographic methods common to the electronics industry. In such embodiments, the dielectric-metal laminate is created from at least two dielectric layers and a conductive layer that are bonded together by thermo-compression, either by roll to roll thermal processing and alternatively, or in addition, by wound roll batch heating.

The conductive layers of the present invention can be formed of any metal, including copper, gold, silver, tungsten or aluminum. In one embodiment, the metal layer is a copper foil. The copper foil can be created in any conventional or non-conventional manner, including electro deposition (ED copper foil) or rolled copper foil (RA copper foil). ED and RA copper foil can be advantageous when used in accordance with the present invention, due to excellent etching properties and excellent bonding (metal foil layer to dielectric layer) characteristics.

The conductive layer thickness can generally be between (and optionally include) any two of the following: 1, 2, 3, 4, 5, 6, 7, 8, 9, 10, 12, 15, 18, 20, 25, 30, 35, 40, 45, 50, 55, 60, 65, 70, 100, 200, 300, 400 and 500 microns, and in one embodiment, the conductive layer thickness is between about 3 to 35 microns. In one embodiment, a copper foil has a coefficient of thermal expansion in a range between (and optionally including) any two of the following: 15, 15.5, 16, 16.25, 16.5, 16.75, and 17 ppm/°C.

The conductive layer can be pre-treated, and such pretreatment may include, but is not limited to, electro-deposition or immersion-deposition along the bonding surface of a thin layer of copper, zinc, chrome, tin, nickel, cobalt, other metals, and alloys of these metals. Such pretreatment may consist of a chemical treatment or a mechanical roughening treatment. Generally speaking, such pretreatment improves adhesion (e.g., peel strength) of the polyimide multilayer to the metal. Apart from roughening the surface, the chemical pretreatment may also lead to the formation of metal oxide groups, enabling improved adhesion between the metal layer and dielectric multilayer. In one embodiment, the pretreatment is applied to both sides of the metal, enabling enhanced adhesion for both sides of the metal.

In one embodiment, the dielectric multilayer includes an adhesive layer for bonding the conductive layer to the dielectric multilayer. The adhesive layer can be formed of a flexible, chemical resistant, heat resistant material, such as, a polyimide. Examples of other materials useful as a dielectric adhesive layer include polyester, polyamide, polyamide-imides, polyimide, polyetherimides, polyether-ketones, polyether-sulfones and liquid crystal polymers. In one such embodiment, the dielectric multilayer is a multilayer polyimide (made by E.I. DuPont de Nemours and Co.), comprising no less than three polyimide layers: i. an adhesive layer, ii. a low coefficient of thermal expansion layer, and iii. a curl balancing layer. The thickness of the multilayer dielectric can be between (and optionally include) any two of the following: 5, 10, 15, 20, 25, 30, 40, 50, 60, 70, 80, 90, 100, 110, 120 and 130 microns. In one embodiment, the dielectric multilayer thickness is between about 8 to 75 microns.

The dielectric multilayer (having at least one adhesive layer) may be continuous or discontinuous. Discontinuous multilayers can have through-holes formed therein. Examples of such through-holes include: i. sprocket holes used for transporting or positioning a film carrier tape for mounting electronic devices; ii. through-holes for use with solder balls; iii. device holes for use with electronic devices; and iv. through-holes for wire bonding use. In one example where the multilayer dielectric has sprocket holes, the conductive layer may be thermo-compression bonded via the adhesive layer to a continuous region of the dielectric multilayer (e.g., other than the side edge regions where the sprocket holes are formed) or to the entire surface of the dielectric multilayer, including the sprocket hole regions, via the adhesive layer.

The adhesive layer (for bonding the dielectric multilayer and the conductive layer) can generally be a high coefficient of thermal expansion polyimide having a glass transition temperature between (and optionally including) any two of the following: 150, 175, 200, 225, 250, 275, 300, 325 and 350°C. The adhesive layer can be derived from aromatic diamine monomers (or other polymerization precursors) and aromatic dianhydrides (or other polymerization precursors) and or a mixture of aromatic and aliphatic (or cyclo-aliphatic) monomers (or other polymerization precursors).

Alternatively, the adhesive layers of the present invention can be made of other materials, such as, epoxies, phenolic resins, melamine resins, acrylic resins, cyanate resins, combinations thereof and the like. Generally, the adhesive layer can have a thickness of between (and optionally including) any two of the following numbers: 1, 3, 5, 8, 10, 15, 20, 25, 30 and 35 microns and can have an in-plane coefficient of thermal expansion between (and optionally including) any two of the following numbers, 25, 30, 35, 40, 45, 50, 55, 60, 65, 70, 75, 80, 85 and 90 ppm/°C.

Useful adhesive layers in accordance with the present invention, include polyimides with bonding temperatures less than (and optionally equal to) 170, 260, 270, 275, 300, 350 and 400°C or glass transition temperatures between 150, 180, 200, 225, 250, 275, 300 and 350°C. Generally speaking, bonding temperatures can be about 20 to 50 degrees higher than the glass transition temperature of the adhesive. Useful such adhesive materials are disclosed in U.S. 5,298,331 and U.S. 7,026,436, to Kanakarajan, et al.

In one embodiment of the present invention, the adhesive layer can be derived from aliphatic diamines having the following structural formula: H₂N-R-NH₂, where R is an aliphatic moiety, such as a substituted or unsubstituted hydrocarbon in a range between (and optionally including) any two of the following: 4, 5, 6, 7, 8, 9, 10, 11, 12, 13, 14, 15, or 16 carbon atoms, and in one embodiment the aliphatic moiety is a C₆ to C₈ aliphatic. In one embodiment, R is a C₆ straight chain hydrocarbon, known as hexamethylene diamine (HMD or 1,6-hexanediamine). In other embodiments, the aliphatic diamine is an alpha, omega-diamine, since such diamines can be more reactive than alpha, beta-aliphatic diamines.

In one embodiment of the present invention, to achieve low temperature bonding of the adhesive layer to the conductive layer "low temperature bonding" is intended to mean bonding in a temperature range between (and optionally including) any two of the following: 180, 185, 190, 195, 200, 205, 210, 215, 220, 225, 230, 235, 240, 245 and 250°C. Here, the mole % of aliphatic diamine (based upon total diamine) can be in a range from about 50, 55, 60, 65, or 70 to about 75, 80, 85 or 90 mole %, or if less than 50 mole % of the diamine component is aliphatic diamine, the resulting polyimide adhesive can have higher bonding temperatures than 250°C. In one instance, for adequate bonding to metal, the lamination temperature is about 20, 22, 25, 28, 30 or 50°C higher than the glass transition temperature of the polyimide adhesive. For example, if the glass transition temperature of the polyimide is in the range of about 150°C to 200°C, then the optimal bonding temperature will be in the range of about 180°C to 250°C.

In one embodiment, the aliphatic diamine is about 65, 70, 75 or 80 mole % hexamethylene diamine (HMD) and the aromatic diamine is 20, 25, 30 or 35 mole % 1,3-bis-(4-aminophenoxy) benzene (APB-134, RODA). In such an embodiment, the glass transition temperature of the resulting polyimide adhesive is in a range of about 165, 170, 175, 180 or about 185°C. Generally speaking, if the lamination temperature (bonding temperature) is between about 190, 195, 200, 210, or 220°C, a polyimide adhesive can oftentimes be used instead of an acrylic or epoxy. Useful applications at such lamination temperatures include polyimide coverlays, or conformal coatings (or encapsulates) in electronics applications.

Depending upon the particular embodiment of the present invention, other aliphatic diamines (including cyclo-aliphatic diamines) can be suitable in preparing the adhesive layer, such as, 1,4-tetramethylenediamine, 1,5-pentamethylenediamine (PMD), 1,6-hexamethylenediamine, 1,7-heptamethylene diamine, 1,8-octamethylenediamine, 1,9-nonamethylenediamine, 1,10-decamethylenediamine (DMD), 1,11-undecamethylenediamine, 1,12-dodecamethylenediamine (DDD), 1,16-hexadecamethylenediamine. In one embodiment, the aliphatic diamine is hexamethylene diamine (HMD).

In one embodiment, the adhesive layer can be derived from a polyimide comprising an aromatic diamine component in an amount within a range between (and optionally including) any two of the following: 5, 10, 15, 20, or 25, 30, 35, 40, 45, and above, but less than 50 mole % of the total diamine component. Other suitable aromatic diamines include, m-phenylenediamine, p-phenylenediamine, 2,5-dimethyl-1,4-diaminobenzene, trifluoromethyl-2,4-diaminobenzene, trifluoromethyl-3,5-diaminobenzene, 2,5-dimethyl-1,4-phenylenediamine (DPX), 2,2-bis-(4-aminophenyl) propane, 4,4'-diaminobiphenyl, 4,4'-diaminobenzophenone, 4,4'-diaminodiphenylmethane, 4,4'-diaminodiphenyl sulfide, 4,4'-diaminodiphenyl sulfone, 3,3'-diaminodiphenyl sulfone, bis-(4-(4-aminophenoxy)phenyl sulfone (BAPS), 4,4'-bis-(aminophenoxy)biphenyl (BAPB), 4,4'-diaminodiphenyl ether, 3,4'-diaminodiphenyl ether, 4,4'-diaminobenzophenone, 4,4'-isopropylidenedianiline, 2,2'-bis-(3-aminophenyl)propane, N,N-bis-(4-aminophenyl)-n-butylamine, N,N-bis-(4-aminophenyl) methylamine, 1,5-diaminonaphthalene, 3,3'-dimethyl-4,4'-diaminobiphenyl, m-amino benzoyl-p-amino anilide, 4-aminophenyl-3-aminobenzoate, N,N-bis-(4-aminophenyl) aniline, 2,4-diaminotoluene, 2,5-diaminotoluene, 2,6-diaminotoluene, 2,4-diamine-5-chlorotoluene, 2,4-diamine-6-chlorotoluene, 2,4-bis-(beta-amino-t-butyl) toluene, bis-(p-beta-amino-t-butyl phenyl) ether, p-bis-2-(2-methyl-4-aminopentyl) benzene, m-xylylene diamine, and p-xylylene diamine.

Other useful aromatic diamines for the adhesive layer include, 1,2-bis-(4-aminophenoxy)benzene, 1,3-bis-(4-aminophenoxy) benzene, 1,2-bis-(3-aminophenoxy)benzene, 1,3-bis-(3-aminophenoxy) benzene, 1-(4-aminophenoxy)-3-(3-aminophenoxy) benzene, 1,4-bis-(4-aminophenoxy) benzene, 1,4-bis-(3-aminophenoxy) benzene, 1-(4-aminophenoxy)-4-(3-aminophenoxy) benzene, 2,2-bis-(4-[4-aminophenoxy]phenyl) propane (BAPP), 2,2'-bis-(4-aminophenyl)-hexafluoro propane (6F diamine), 2,2'-bis-(4-phenoxy aniline) isopropylidene, 2,4,6-trimethyl-1,3-diaminobenzene, 4,4'-diamino-2,2'-trifluoromethyl diphenyloxide, 3,3'-diamino-5,5'-trifluoromethyl diphenyloxide, 4,4'-trifluoromethyl-2,2'-diaminobiphenyl, 2,4,6-trimethyl-1,3-diaminobenzene, 4,4'-oxy-bis-[2-trifluoromethyl)benzene amine] (1,2,4-OBABTF), 4,4'-oxy-bis-[3-trifluoromethyl)benzene amine], 4,4'-thio-bis-[(2-trifluoromethyl)benzeneamine], 4,4'-thiobis[(3-trifluoromethyl)benzene amine], 4,4'-sulfoxyl-bis-[(2-trifluoromethyl)benzene amine, 4,4'-sulfoxyl-bis-[(3-trifluoromethyl)benzene amine], and 4,4'-keto-bis-[(2-trifluoromethyl)benzene amine].

In one embodiment, the aromatic diamine for the adhesive layer can be isomers of bis-aminophenoxybenzenes (APB), dimethylphenylenediamine (DPX), bisaniline P, and combinations thereof. Such diamines can lower the lamination temperature of the adhesive, and will generally increase the peel strength of the adhesive to other materials, especially metals.

In one embodiment, any aromatic dianhydride or combination of aromatic dianhydrides, can be used as the dianhydride monomer in forming the adhesive layer of the dielectric multilayer. These dianhydrides may be used alone or in combination with one another. The dianhydrides can be used in their tetra-acid form (or as mono, di, tri, or tetra esters of the tetra acid), or as their diester acid halides (chlorides). However in some embodiments, the dianhydride form can be preferred, because it is generally more reactive than the acid or the ester.

Examples of suitable aromatic dianhydrides for the adhesive layer include, 1,2,5,6-naphthalene tetracarboxylic dianhydride, 1,4,5,8-naphthalene tetracarboxylic dianhydride, 2,3,6,7-naphthalene tetracarboxylic dianhydride, 2-(3',4'-dicarboxyphenyl) 5,6-dicarboxybenzimidazole dianhydride, 2-(3',4'-dicarboxyphenyl) 5,6-dicarboxybenzoxazole dianhydride, 2-(3',4'-dicarboxyphenyl) 5,6-dicarboxybenzothiazole dianhydride, 2,2',3,3'-benzophenone tetracarboxylic dianhydride, 2,3,3',4'-benzophenone tetracarboxylic dianhydride, 3,3',4,4'-benzophenone tetracarboxylic dianhydride (BTDA), 2,2',3,3'-biphenyl tetracarboxylic dianhydride, 2,3,3',4'-biphenyl tetracarboxylic dianhydride, 3,3',4,4'-biphenyl tetracarboxylic dianhydride (BPDA), bicyclo-[2,2,2]-octen-(7)-2,3,5,6-tetracarboxylic-2,3,5,6-dianhydride, 4,4'-thio-diphthalic anhydride, bis (3,4-dicarboxyphenyl) sulfone dianhydride, bis (3,4-dicarboxyphenyl) sulfoxide dianhydride (DSDA), bis (3,4-dicarboxyphenyl oxadiazole-1,3,4) p-phenylene dianhydride, bis (3,4-dicarboxyphenyl) 2,5-oxadiazole 1,3,4-dianhydride, bis 2,5-(3',4'-dicarboxydiphenylether) 1,3,4-oxadiazole dianhydride, 4,4'-oxydiphthalic anhydride (ODPA), bis (3,4-dicarboxyphenyl) thio ether dianhydride, bisphenol A dianhydride (BPADA), bisphenol S dianhydride, 2,2-bis-(3,4-dicarboxyphenyl) 1,1,1,3,3,3,-hexafluoropropane dianhydride (6FDA), 5,5-[2,2,2]-trifluoro-1-(trifluoromethyl)ethylidene, bis-1,3-isobenzofurandione, 1,4-bis(4,4'-oxyphthalic anhydride) benzene, bis (3,4-dicarboxyphenyl) methane dianhydride, cyclopentadienyl tetracarboxylic acid dianhydride, cyclopentane tetracarboxylic dianhydride, ethylene tetracarboxylic acid dianhydride, perylene 3,4,9,10-tetracarboxylic dianhydride, pyromellitic dianhydride (PMDA), tetrahydrofuran tetracarboxylic dianhydride, 1,3-bis-(4,4'-oxydiphthalic anhydride) benzene, 2,2-bis(3,4-dicarboxyphenyl) propane dianhydride, 2,6-dichloronaphthalene-1 ,4,5,8-tetracarboxylic dianhydride, 2,7-dichloronaphthalene-1,4,5,8-tetracarboxylic dianhydride, 2,3,6,7-tetrachloronaphthalene-1,4,5,8-tetracarboxylic dianhydride, phenanthrene-1,8,9,10-tetracarboxylic dianhydride, pyrazine-2,3,5,6-tetracarboxylic dianhydride, benzene-1 ,2,3,4-tetracarboxylic dianhydride; and thiophene-2,3,4,5-tetracarboxylic dianhydride.

Generally, the low coefficient of thermal expansion polyimide layer is used to provide an overall CTE (of the dielectric multilayer) that is sufficiently close to the CTE of the conductive layer to inhibit unwanted curl. In one embodiment, the coefficient of thermal expansion of this layer can be between 5, 10, 15, 20, 25 and 30 ppm/°C. The low coefficient of thermal expansion layer is generally positioned within in the dielectric-metal multilayer structure adjacent to the adhesive layer and optionally, on the opposite side of the conductive layer. The thickness of the low coefficient of thermal expansion layer can be between (and optionally including) any two of the following: 10, 20, 30, 40, 50, 60, 70, 80, 90 and 100 microns. Generally, the low coefficient of thermal expansion layer is derived from a polyimide or perhaps a polyimide composite, however other polymers are also possible. Furthermore, the thickness of the low coefficient of thermal expansion layer can be tailored to control flatness of the dielectric-laminate structure or provide thermal dimensional stability of the laminate (or circuit trace etched laminate).

In one embodiment of the present invention, the low coefficient of thermal expansion layer comprises a sufficiently high T_{g} polyimide to exhibit "thermosetting" type properties. Such polyimides can be derived from: i. aromatic dianhydrides, such as, PMDA, BPDA, BTDA and the like; and ii. aromatic diamines such as p-phenylene diamine, m-phenylene diamine, 3,4'-oxydianiline, 4,4'-oxydianiline, and substituted (or unsubstituted) biphenyldiamine. Additional co-monomers can optionally be used in synthesizing the preferred polyimide polymers of the present invention, provided that the additional co-monomers are less than 30, 25, 20, 15, 10, 5, 2, 1 or 0.5 mole percent of the final polyimide polymer. Examples that may be used as an additional co-monomer for embodiments of the present invention include but are not limited to:
1. 2,3,6,7-naphthalene tetracarboxylic dianhydride;
2. 1,2,5,6-naphthalene tetracarboxylic dianhydride;
3. benzidine;
4. substituted benzidine (e.g., 2,2'-bis(trifluoromethylbenzidine)
5. 2,3,3',4'-biphenyl tetracarboxylic dianhydride;
6. 2,2',3,3'-biphenyl tetracarboxylic dianhydride;
7. 3,3',4,4'-benzophenone tetracarboxylic dianhydride;
8. 2,3,3',4'-benzophenone tetracarboxylic dianhydride;
9. 2,2',3,3'-benzophenone tetracarboxylic dianhydride;
10. 2,2-bis(3,4-dicarboxyphenyl) propane dianhydride;
11. bis(3,4-dicarboxyphenyl) sulfone dianhydride;
12. 1,1-bis(2,3-dicarboxyphenyl) ethane dianhydride;
13. 1,1-bis(3,4-dicarboxyphenyl) ethane dianhydride;
14. bis(2,3-dicarboxyphenyl) methane dianhydride;
15. bis(3,4-dicarboxyphenyl) methane dianhydride;
16. 4,4'-(hexafluoroisopropylidene) diphthalic anhydride
17. oxydiphthalic dianhydride;
18. bis(3,4-dicarboxyphenyl) sulfone dianhydride;
19. bis(3,4-dicarboxyphenyl) sulfoxide dianhydride;
20. thiodiphthalic dianhydride;
21. 2,2 bis-(4-aminophenyl) propane;
22. 4,4'-diamino diphenyl methane;
23. 4,4'-diamino diphenyl sulfide;
24. 3,3'-diamino diphenyl sulfone;
25. 4,4'-diamino diphenyl sulfone;
26. 4,4'-diamino diphenyl ether;
27. 1,5-diamino naphthalene;
28. 4,4'-diamino-diphenyl diethylsilane;
29. 4,4'-diamino diphenylsilane;
30. 4,4'-diamino diphenyl ethyl phosphine oxide;
31. 4,4'-diamino diphenyl N-methyl amine;
32. 4,4'-diamino diphenyl-N-phenyl amine;
33. 1,3-diaminobenzene;
34. 1,2-diaminobenzene;
35. 2,2-bis(4-aminophenyl) 1,1,1,3,3,3-hexafluoropropane;
36. 2,2-bis(3-aminophenyl) 1,1,1,3,3,3-hexafluoropropane;
37. and the like.

Multilayer dielectrics according to the present invention can be used as a base film for dielectric-metal laminates and incorporated into flexible printed circuit boards ("FPCs"). In one embodiment, a flexible printed circuit board ("FPC") can be produced as follows:
1. apply an adhesive (onto a low coefficient of thermal expansion film) and dry the adhesive;
2. laminate a copper or other conductive foil;
3. harden/cure the adhesive; and
4. form a circuit pattern (such as, by applying a resist, then photopatterning, then developing the resist, then metal etching and then removal of the resist).

The curl balancing layer of the present invention can be an adhesive-type film (or a high coefficient of thermal expansion layer as describe above) or can be a non-adhesive type film having a high coefficient of thermal expansion. As such, the curl balancing layer can be a polyimide having an in-plane coefficient of thermal expansion between 10 and 80 ppm/°C as determined by ASTM Method IPC-650 2.4.41. In certain applications, the curl balancing layer can be a high coefficient of thermal expansion layer having a higher Tg than typical adhesives to aid in balancing 'severe' amounts of curl in a dielectric-metal laminate (i.e. amounts of curl not capable of being balanced by a low coefficient of thermal expansion layer alone). On the other hand, the curl balancing layer can have a low coefficient of thermal expansion layer to reduce unwanted thermal dimensional instability.

The curl balancing layer of the present invention can have a thickness between (and optionally including) any two of the following: 1, 3, 5, 8, 10, 15, 20, 25, 30 and 35 microns, and can have a coefficient of thermal expansion between (and optionally including) any two of the following: 5, 10, 15, 20, 25, 30, 35, 40, 45, 50, 55, 60, 65, 70, 75, 80, 85 and 90 ppm/°C. The curl balancing layer of the present invention can be similar (or identical) to the adhesive layer, provided the curl balancing layer has a glass transition temperature between (and optionally including) any two of the following: 150, 175, 200, 225, 250, 275, 300, 325 and 350°C. In this manner, the curl balancing layer can act as a second adhesive layer so that the dielectric-metal laminate can be bonded (e.g. in a subsequent process) to another material or substrate, typically a second conductive layer to form a two-sided metal laminate. Here, the second conductive layer can be the same or different than the conductive layer and can have a different thickness, a different surface roughness or surface treatment, or can be an entirely different material than a metal foil.

In one embodiment:
i. the adhesive layer(s),
ii. the low coefficient of thermal expansion layer(s), and
iii. the curl balancing layer(s)
are cast from their polyamic acids precursor forms, using a multi-port die to form the multilayer polyimides of the present invention. These multi-layer polyimides can then be bonded to a metal, typically using the adhesive layer as the bonding medium to the metal.

In one embodiment, the dielectric-metal laminate can comprise at least one layer of a polyimide base film (the low coefficient of thermal expansion layer), an adhesive layer, and at least one layer of polyimide for use either as a second adhesive layer or as a second low CTE stiffening layer.

Dielectric -metal laminates of the present invention can be useful for mounting electronic devices. Such laminates can be manufactured in a following manner: i. a dielectric multilayer (comprising an adhesive layer, a low coefficient of thermal expansion layer, and a curl balancing layer) is unwound; ii. a complementary conductive layer is also unwound at substantially the same time, and iii. the two layers are positioned together and fed into a thermo-compression bonding apparatus, such as, a series of nip bonding rollers. In one embodiment, a dielectric compression nip roller and a complementary conductive layer nip roller work in tandem to heat press the two layers together. Either one or both of the compression nip rollers may be heated.

In one embodiment, the temperature of the dielectric compression nip roller is kept at a temperature that is generally below the bonding temperature (and sometimes below the glass transition temperature) of the adhesive layer, thereby preventing thermally compressed laminate from sticking (or blocking) to either the compression nip roller or the adhesive layer after winding.

In an embodiment intended to ensure that the conductive layer is firmly compressed into the adhesive layer, the temperature of the conductive layer compression nip roller is kept at a temperature that is greater than the glass transition temperature of the adhesive layer. Generally, it is desirous to firmly implant the dendrite or "tooth" (i.e. the surface roughness) of the conductive layer into the adhesive layer using heat energy at a temperature and pressure high enough to allow the adhesive layer to flow, even if in the smallest degree (or be mechanically forced), into the surface of the metal. Although the bond strength may still be quite low at this stage (i.e. since the adhesive and the metal are not heat-sealed) it is generally useful for the interface of the conductive layer and the adhesive layer to have good contact across the z-directional topographies of both materials (i.e. both surfaces).

Generally, the temperature of the dielectric-side compression nip roller can be maintained at a wide variety of temperatures to aid in processing of the laminates of the present invention. In one instance, the temperature of the dielectric-side compression nip roller is maintained at room temperature or below. In another instance, the temperature of the dielectric nip roller is maintained at a temperature of about 1, 2, 3, 4, 5, 6, 7, 8, 9, 10, 15, 20, 25, 30 or 50 degrees Celsius below the glass transition temperature of the adhesive layer.

In one embodiment, the dielectric side compression nip roller temperature is maintained at a temperature below the glass transition temperature of the adhesive layer. In such embodiments, the laminate is not heat-sealed at a bonding temperature that is useful in many end use applications. As such, these laminates are generally "compression bonded" and then later heat-sealed in a batch operation using an oven. Typically, bond values during compression bonding can be between (and optionally include) any two of the following: 0.01, 0.05, 0.1, 0.2, 0.3, 0.4, 0.5, 0.6, 0.7, 0.8, 0.9 or 1.0 N/cm per ASTM Method IPC-TM-650 Method No. 2.4.9.D. In one embodiment, a subsequent "heat-sealing step" can fully bond the adhesive layer to the conductive layer, and optionally the curl balancing layer to a second conductive layer or alternative substrate(s) or materials to provide bond values between (and optionally include) any two of the following: 1.0, 1.2, 1.4, 1.6, 1.8, 2.0, 3.0, 4.0, 5.0, 6.0, 7.0, 8.0, 9.0, 10.0, 12.0, 14.0, 16.0, 18.0, 20.0 and 25.0 N/cm per ASTM Method IPC-TM-650 Method No. 2.4.9.D.

"Compression bonded" is intended to mean a processing step where an adhesive layer (or curl balancing layer) is put in contact with a conductive layer at a temperature below the glass transition temperature of the adhesive (or curl balancing) layer at a pressure ranging from 1 atmosphere to about 1000 atmospheres.

"Heat sealing" is intended to mean a thermal processing step where an adhesive layer (or curl balancing layer) is put in contact with a conductive layer at a temperature greater than the glass transition temperature of the adhesive layer (or curl balancing layer), preferably at least 20 degrees Celsius or more above the glass transition temperature of the adhesive layer at a pressure ranging from 1 atmosphere to about 1000 atmospheres. Useful bonding pressures can range from between (and optionally including) any two of the following: 10, 20, 30, 40, 50, 100, 150, 200, 250, 300, 350, 400, 450, 500 up to 1000 pounds per square inch (PSI). Alternatively or in addition, a linear force up to (and optionally including) 100, 150, 200, 250, 300, 350, 400, 450 or 500 KN/m can be applied. To prevent the conductive layer from oxidizing, a nitrogen (or inert gas) atmosphere can be used. Heat sealing in the present invention can be performed in-line (i.e. using the same or similar equipment) as the thermal compression bonding step or can be done off-line (i.e. using different equipment).

In-line heat sealing, as herein defined, can refer to passing thermally bonded dielectric-metal laminates continuously through a double belt press (comprising of at least two metal belts applying heat and pressure to the laminate) or through a second stage compression nip roller apparatus. Sometimes, processing time can be slow so that good bonding is achieved. On the other hand, thermally compressed dielectric-metal laminates of the present invention can be heat-sealed off-line in a second stage heating processing step like an oven. This type of heat sealing step may comprise putting a loosely wound dielectric-metal (thermally compressed) bonded roll into a high-energy oven (either a convective oven, a radiant oven or a combination of the two). Oven temperatures can be raised well above the glass transition temperature of the adhesive layer (or curl balancing layer) and pressure (and atmospheric) conditions can be controlled. In essence, the laminates of the present invention can be prepared in a faster manner than using a purely compression nip roller apparatus, i.e. an apparatus that operates at low temperatures to achieve good thermal compression bonding, and then higher temperatures to heat seal using either nip rollers, belt-type presses or both.

In one embodiment of the present invention, two conductive layers are processed along with one dielectric layer prepared by simultaneously casting, through co-extrusion, an adhesive layer on both sides of a low coefficient of thermal expansion layer. Two conductive layer-side compression nip rollers are set at temperatures at or above the glass transition temperature of each respective adhesive layer in order to achieve good penetration of the surface of the conductive layer into the surface of the corresponding adhesive layer. Here, the two-sided dielectric-metal laminate is loosely wound into a roll and placed into a high-energy convective oven at a temperature of about 100 degrees higher than the higher glass transition temperature of the adhesive layers at a pressure of 350 PSI in a nitrogen atmosphere. Bond values of the heat sealed two-sided dielectric-metal laminate can be between and including any two of the following numbers, 1, 2, 3, 4, 5, 6, 7, 8, 10, 15, 20 and 25 N/cm.

In another embodiment of the present invention, a conductive layer is processed with one dielectric layer having a low coefficient of thermal expansion layer on each side. In such an embodiment, the conductive layer compression nip roller can be set at a temperature at or above the glass transition temperature of the adhesive layer to achieve useful penetration of the surface of the conductive layer into the surface of the adhesive layer. In one embodiment, a one-sided dielectric-metal laminate is loosely wound into a roll and placed into a high-energy convective oven at a temperature of about 100 degrees higher than the higher glass transition temperature of the adhesive layer, at a pressure of 350 PSI, in a nitrogen atmosphere. Bond values of the heat sealed one-sided dielectric-metal laminate can be between (and optionally include) any two of the following: 1, 2, 3, 4, 5, 6, 7, 8, 10, 15, 20 and 25 N/cm.

The heat-sealed dielectric-metal laminates of the present invention can be used for mounting an electronic device or can be used as a film carrier tape. In addition, these laminates can be used for packaging electronic circuits, the laminate being used in a chip on lead ("COL") package, a chip on flex ("COF") package, a lead on chip ("LOC") package, a multi-chip module ("MCM") package, a ball grid array ("BGA" or "µ-BGA"), package, chip scale package ("CSP"), a tape automated bonding ("TAB") package, or used in a wafer level integrated circuit package.

The advantageous properties of this invention can be observed by reference to the following examples that illustrate, but do not limit, the invention. All parts and percentages are by weight unless other wise indicated.

### EXAMPLE 1

A three-layer polyimide film having a thickness of about 25.0 microns and having a core layer having a Tg >300°C, and an adhesive layer having a Tg of <250C, and a curl balancing layer having a Tg of <250°C is laminated to a copper foil, on one side using the thermo-compression apparatus shown below.

The 25-micron, three-layer polyimide film has an adhesive layer thickness of about three microns and a Tg of about 195°C. The core layer (a low in-plane coefficient of thermal expansion layer) has a thickness of about 19 microns and a Tg of about 350°C. The copper foil has a thickness of about 12 microns.

R₁ below is the conductive layer nip roller and R₂ is the dielectric layer nip roller. The temperature of the compression nip roller on the metal foil side was set at 275°C. The lower compression nip roller (R₂) temperature was set at 190°C.

The lamination speed was between 1 meter/min. to about 5 meters/min. The peel strength obtained in the dielectric metal laminate produced was at about 0.5 N/cm. This dielectric metal laminate was subsequently heated above 290°C for more than 10 seconds in solder pot (a liquid solder heating medium). The peel strength of the dielectric metal laminate was increased from 0.5 N/cm to about 15 N/cm.

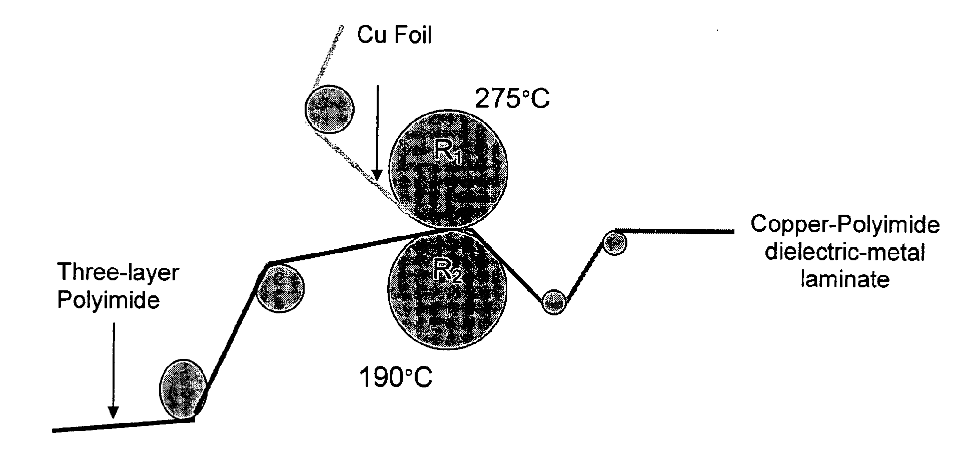

### EXAMPLE 2

EXAMPLE 2 was prepared in accordance with EXAMPLE 1 except the three-layer polyimide film was 50.0 microns in thickness.

### COMPARATIVE EXAMPLE 1

COMPARATIVE EXAMPLE 1 was prepared in accordance with EXAMPLE 1 however the bottom compression nip roller temperature was set at 275°C. Here, the dielectric metal laminate bonded to the roller causing the laminate to be non-functional.

## Claims

1. A multilayer laminate comprising:
a. a conductive layer selected from the group consisting of copper, aluminum, nickel, steel, and alloys thereof, and
b. a dielectric multilayer comprising:
i. an adhesive layer adjacent to the conductive layer,
ii. a low coefficient of thermal expansion layer adjacent to the adhesive layer, and
iii. a curl balancing layer adjacent to the low coefficient of thermal expansion layer.

2. A multilayer laminate in accordance with Claim 1 wherein the adhesive layer, the low coefficient of thermal expansion layer and the curl balancing layer are cast simultaneously as a multi-layer film via a co-extrusion process and then laminated to a conductive layer by thermo-compression bonding and a subsequent heating step.

3. A laminate in accordance with Claim 1 wherein adhesive layer is derived from a polyimide having a glass transition temperature between 150 and 300 degrees Celsius.

4. A laminate in accordance with Claim 1 wherein the low coefficient of thermal expansion layer is derived from a polyimide having an in-plane coefficient of thermal expansion between 10 and 30 ppm/°C as determined by ASTM Method IPC-650 2.4.41.

5. A laminate in accordance with Claim 1 wherein the curl balancing layer is derived from a polyimide having an in-plane coefficient of thermal expansion between 10 and 80 ppm/°C as determined by ASTM Method IPC-650 2.4.41.

6. A laminate in accordance with Claim 1 further comprising a second conductive layer adjacent to the curl balancing layer.

7. A laminate in accordance with Claims 7 wherein the adhesive layer and the curl balancing layer are derived from a thermoplastic polyimide adhesive having a glass transition temperature between 150 and 300 degrees Celsius.

8. A laminate in accordance with Claim 1 wherein the conductive layer and the dielectric layer have a bond strength between 1.0 to 25.0 N/cm as determined by ASTM Method IPC-TM-650 Method No. 2.4.9.D.

9. A laminate in accordance with Claim 1 wherein the curl balancing layer is used as an adhesive to bond the laminate to a copper foil, an aluminum foil, a nickel foil, a steel foil, and foils made of alloys thereof.

10. A laminate in accordance with Claim 1 wherein the curl balancing layer is used as an adhesive to bond the laminate to a printed circuit board.
